# EUROPEAN PATENT APPLICATION

(11) **EP 2 073 269 A1**
(43) Date of publication of application: **24.06.2009**
(21) Application number: 08101700.6
(22) Date of filing: 18.02.2008
(51) Int. Cl.: H01L 27/142, H01L 31/18

(54) **Method for providing a series connection in a solar cell system**

(30) Priority: 21.12.2007 EP 07123962
(71) Applicant: Helianthos B.V., 6824 BM Arnhem (NL)
(72) Inventor: Sportel, Edwin Peter, 6846 CE, Arnhem (NL)
(74) Representative: Hesselink, Dinah Elisabeth

(57) **Abstract**

The present invention pertains to a process for providing a series connection in a solar cell system comprising the provision of a solar cell system comprising a transparent conductive oxide layer, a photovoltaic layer, and a back electrode, wherein the system is divided into at least two individual cells wherein the transparent conductive oxide layer of one cell is connected through a conductive interconnect with the back electrode of an adjacent cell, and the transparent conductive oxide layer is provided with an insulating interrupt on one side of the interconnect and the back electrode is provided with an interrupt on the other side of the interconnect, the process being **characterised in that** the interrupt in the transparent conductive oxide layer is provided through vitrification of the transparent conductive oxide layer.

A solar cell system provided with a series connection wherein the interrupt in the TCO layer is made up of a vitrified section of the TCO is also claimed.

## Description

The present invention pertains to a method for providing a series connection in a solar cell system, and to a solar cell system comprising solar cells connected in series.

Solar cells, also known as photovoltaic cells, generally comprise a carrier and a photovoltaic (PV) layer composed of a semiconductor material provided between a front electrode comprising a transparent conductive oxide (TCO) (on the light-receiving side of the cell) and a back electrode (at the back of the cell). The front electrode is transparent, enabling incident light to reach the semiconductor material, where the incident radiation is converted into electric energy. In this way light can be used to generate electric current, which offers an interesting alternative to, say, fossil fuels or nuclear power.

The maximum voltage of a solar cell is determined by the composition of the cell, more in particular by the nature of the semiconductor material, and by the intensity of the incident light. When the surface area of the solar cell is increased, more power is generated, but the voltage remains the same. In order to increase the voltage, a solar cell is often divided into individual subcells, which are connected in series to form a solar cell system. This is done by establishing a conductive contact, also indicated as interconnect, between the front electrode of one cell and the back electrode of another, while interrupting the front electrode and the back electrode each at a different side of the interconnect so as to prevent short-circuiting. This can be done by providing grooves in the solar cell electrode layers, e.g., by using a laser or by means of etching or any other patterning method. To minimise the region in the solar cell which does not generate any energy, the interconnect and the interrupts must be as close together as possible and the interconnect and the interrupts must be as narrow as possible.

In one embodiment known in the art, series connection is effected as follows: A transparent conductive oxide (TCO) layer that is deposited onto a (glass) substrate is patterned with parallel grooves, which form the interrupts in the front electrode. The photovoltaic (PV) layer that is deposited over the TCO layer is also patterned with parallel grooves, which form the basis for the interconnects between the front electrode of one cell and the back electrode of an adjacent cell. The back electrode is then deposited over the PV layer, and patterned with grooves to form the interrupts. The interconnect is formed by the back electrode material deposited in the groove in the PV layer.

Another process for manufacturing a series connection in a solar cell system has been proposed by P. Pernet et al., Proc. 2nd World Conference PV, Wien, July 1998. According to that process, after depositing the metal back electrode, the photovoltaic layer and the ITO or ZnO front electrode on a substrate, three grooves of different depths are provided using selective laser scribing in one process step. The deepest groove down to the substrate is filled with an insulating compound to form the interrupt in the back electrode. The second deepest groove down to the metal back electrode is filled with a conducting paste that overlaps the insulating paste in the deepest groove to form the interconnect. The shallowest groove down to the photovoltaic layer is the interrupt in the front electrode.

WO 2203001602 describes a method for manufacturing a solar cell provided with a series connection via a method using a temporary substrate, which method, int. al., comprises the step of providing a groove from the light-incident side of the final solar cell system through the transparent conductive oxide front electrode.

As indicated above, in the process for providing a series connection, it is always necessary to interrupt the electrodes on each side of the interconnect between the front electrode of one solar cell and the back electrode of the other cell to prevent short-circuiting. In many processes this involves the provision of grooves through the front electrode, which is a layer of a transparent conductive oxide, and which will also be indicated as a TCO layer, which groove is then filled with an insulating material.
It has been found that the provision of grooves through the TCO layer, which is generally carried out using a laser, has a number of disadvantages.
In the first place, scribing a groove in the TCO layer may result in damage to the material underlying the TCO later. The debris from this material, which may, for example be metal if the underlying material is a metal substrate, can contaminate the solar cell system, and for example form shunts. This is applicable both when the groove is applied on the TCO layer as such, but also when the scribing step takes place through layers covering the TCO layer, such as the photovoltaic layer and optionally the back electrode layer. The damage to the substrate as such may also detrimentally affect the properties of the system. The same applies when the TCO layer is present on top of a photovoltaic layer when the grooves are provided. The provision of the grooves in the TCO layer may result in damage to the underlying PV layer.
In the second place, in cases where the substrate underlying the lower electrode is a temporary substrate, the insulating groove through the underlying electrode may form a weakness in the system. For example, WO 98/13882 and WO99/49483 describe a method for manufacturing a photovoltaic foil comprising the steps of providing a temporary substrate, which is, e.g., an aluminium foil, applying a transparent conductive oxide layer onto the temporary substrate as front electrode, applying a photovoltaic layer onto the TCO layer, applying a back electrode layer onto the photovoltaic layer, applying a carrier onto the back electrode, and removing the temporary substrate. In providing a series connection in these systems, a groove may be applied through the TCO layer (and optionally through the PV layer and if present the back electrode), onto the temporary substrate, which is then filled with an insulating material. When the temporary substrate is then removed through, e.g., an etching process, the groove and the insulating material present therein come into contact with the etchant, which can damage the series connection.
A general problem underlying the manufacture of solar cell systems comprising solar cells connected in series is that each scribing step requires a dedicated laser, with associated investment costs, and that laser scribing is an energy-intensive, and therewith a cost-intensive process.

Accordingly, there is need for a series connection process wherein the provision of grooves though the TCO layer is avoided. There is also need for a process for providing a series connection in which the provision of grooves through a TCO layer which is present on a temporary substrate is avoided. The present invention provides such a process. Other advantages of the process according to the invention and of specific embodiments thereof will become apparent from the following specification.

The present invention is directed to a process for providing a series connection in a solar cell system comprising the provision of a solar cell system comprising a transparent conductive oxide layer, a photovoltaic layer, and a back electrode, wherein the system is divided into at least two individual cells wherein the transparent conductive oxide layer of one cell is connected through a conductive interconnect with the back electrode of an adjacent cell, and the transparent conductive oxide layer is provided with an insulating interrupt on one side of the interconnect and the back electrode is provided with an interrupt on the other side of the interconnect, the process being characterised in that the interrupt in the transparent conductive oxide layer is provided through vitrification of the transparent conductive oxide layer.
The present invention also pertains to a solar cell system comprising a transparent conductive oxide layer, a photovoltaic layer, and a back electrode, the system comprising at least two individual cells with the transparent conductive oxide layer of a cell being connected through a conductive interconnect with the back electrode of an adjacent cell, wherein the transparent conductive oxide layer is provided with an insulating interrupt on one side of the interconnect and the back electrode is provided with an interrupt on the other side of the interconnect, characterised in that the interrupt in the transparent front electrode is made up of vitrified transparent conductive oxide.

The crux of the present invention is the recognition that an interrupt in the transparent conductive oxide layer (also indicated as TCO layer) can be obtained by vitrifying the TCO. Suitable transparent conductive oxides include indium tin oxide, zinc oxide, zinc oxide doped with aluminum, fluorine, gallium, or boron, cadmium oxide, tin oxide, metal stannates, such as Zn or Cd stannates, and F-doped SnO2, Sb-doped SnO2, p-doped TCO, such as cuprates, for example Sr-based cuprates.
The vitrification process transforms the transparent conductive oxide to form a transparent insulating interrupt. The vitrification process can be carried out by providing the TCO layer with energy, for example using a laser, wherein the amount of energy provided is sufficient to vitrify the TCO layer, but insufficient to cut through the layer. Selection of an appropriate vitrification method, including selection of a laser with the appropriate wavelength, is within the scope of a skilled person. In one embodiment, where the vitrification step is carried out on the TCO when it is not overlayed by another layer, UV layers are generally suitable. Examples include triplet or quadruplet Nd lasers and eximer (puls) lasers. The light emitted by these lasers is selectively absorbed by the TCO layer, which leads to vitrification of the TCO layer.
In another embodiment, where the TCO is overlayed with a silicon PV layer and optionally a back electrode when the vitrification step is carried out, a suitable vitrification process comprises the use of a "green" (532 nm) laser. This laser melts the silicon layer. The silicon layer transports the heat to the TCO layer, which is then vitrified.

In one embodiment the TCO layer is present on a permanent substrate, e.g., a glass substrate or a temperature resistant transparent polymer substrate, when the vitrification process is carried out. Within the context of the present specification a permanent substrate is a substrate which will not be removed before the solar cell is ready for use. In another embodiment, the TCO layer is be present on a temporary substrate when the vitrification process is carried out, e.g., when use is made of a process as described in WO 98/13882 or WO99/49483. Within the context of the present specification a temporary substrate is a substrate which will be removed from the TCO before the solar cell is suitable for use. In a further embodiment the TCO layer is on a photovoltaic layer when the vitrification process is carried out. This embodiment may be less preferred.

The vitrification process can be carried out on the TCO layer as such, that is, by providing energy to the TCO layer directly, for example by using a suitable laser.
It is also possible to combine the vitrification step with the provision of a groove through a photovoltaic layer, e.g., using a suitable laser. In this case, the amount of energy provided by the laser is selected to be such that a groove is provided through the PV layer and at the same time sufficient to vitrify the TCO layer below the PV layer. This process is especially effective when a silicon-based PV layer is used. Because silicon is a good energy absorber when the appropriate laser is selected, the silicon layer will become very hot, which will contribute to the vitrification of the TCO layer.
It is also possible to combine the vitrification step with the provision of a groove through a photovoltaic layer and a back electrode layer, for example using a suitable laser. Again, in this case, the amount of energy provided by, for example, the laser is selected to be such that a groove is provided through the back electrode layer, through the PV layer and at the same time sufficient to vitrify the TCO layer below the PV layer. In this embodiment it will generally be necessary to provide a "bridge" over the insulating material in the back electrode, to provide a connection in the back electrode. For that reason, this embodiment is considered less preferred.

The manner in which the series connection is carried out is not critical to the present invention. In general, the series connection is established by ensuring that the front electrode of one cell and the back electrode of an adjacent cell are electrically connected in an interconnect while the front and the back electrode are each interrupted at different sides of the interconnect.

The interrupt in the TCO layer is made by vitrification. Depending on the manufacturing method of the interrupt, it may be accompanied by a groove in the PV layer and optionally through the back electrode. If a groove is present in these layers, it will be filled with an insulating material.
The interrupt in the back electrode is generally applied by making a groove using a laser and filling the groove with an insulating material. Depending on the manufacturing method of the interrupt, it may be accompanied by a groove in the PV layer. If a groove is present in the PV layer it will be filled with an insulating material.

To protect the underlying layers when grooves are applied, strips of an insulating material may be applied at the location where the interrupting grooves are to be applied. The insulating material will act as laser stop to prevent the formation of short-circuits by melting of the underlying material. For some of the embodiments to be discussed below, the provision of strips of an insulating material will be described explicitly, but they may be applied also in other embodiments. The insulating material may be applied on the TCO layer and/or on the PV layer, as applicable.

The interconnect can be established in various manners. It can be established by applying a groove through the PV layer and filling it with a conductive material. The groove may or may not extend through the TCO layer, through the back electrode layer, or through both the TCO layer and the back electrode layer. This will depend, int. al., on the process step in which the groove is applied. In one embodiment, the conductive material which is used to fill the groove in the PV layer is back electrode material. If the PV layer is an amorphous Si layer, the conductive connection can also be established by fusing the amorphous Si layer with the back electrode. If the PV layer is an amorphous Si layer, the interconnect can also be established by recrystallising the Si into a conductive material. This option is less preferred, however. Extending of the groove for the interconnect through the TCO layer may be less preferred where it is desired not to damage the layer underlying the TCO layer.

The sequence in which the interconnect and the interrupting grooves are applied is not critical and will depend on what is most suitable in the specific process applied.

The width of the interconnect and the interrupts generally is determined by the following considerations. At the sites of the interconnect and the interrupts, the solar cell is unable to convert light into electricity. In view of this, the interconnect and the interrupts have to be as narrow as possible. On the other hand, they have to be wide enough to ensure that the desired effect, the interruption of the different layers and the connection of the front and the back electrode with sufficient conductivity, is attained.
The interrupts generally have a width of 2 to 400 microns, preferably of 5 to 250 microns. The interconnect generally has a width of 0.1 to 200 microns, preferably of 5 to 50 microns.

The distance between the interrupts and the interconnect of an individual series connection, where they are present in different grooves is generally between 5 and 500 microns, more in particular between 10 and 250 microns.

When applied, the strips of an insulating material that may be applied at the location where the interrupts are to be applied should be wide enough to allow for easy provision of the interrupting grooves within the width of the strips. In general, the strips have a width between 25 and 1,000 microns, preferably between 50 and 400 microns, more preferably between 50 and 200 microns.

Various embodiments of the process and system according to the invention can be envisaged.

A first embodiment of the present invention comprises the steps of:
- providing a substrate (1) which is either a transparent permanent substrate or a temporary substrate
- applying a transparent conductive oxide layer (2) onto the substrate and ensuring vitrification of a section (v) of the transparent conductive oxide layer,
- applying a photovoltaic layer (3) (PV layer) onto the TCO layer, and providing grooves in the PV layer down to the TCO layer
- applying a back electrode layer (4) onto the PV layer and in the grooves present in the PV layer so as to form an interconnect (6) which connects the back electrode layer to the transparent conductive oxide layer, and providing grooves (bg) in the back electrode layer down to the PV layer
- applying a covering layer (5) on the back electrode, and
- where the substrate (1) is a temporary substrate, removing the temporary substrate.

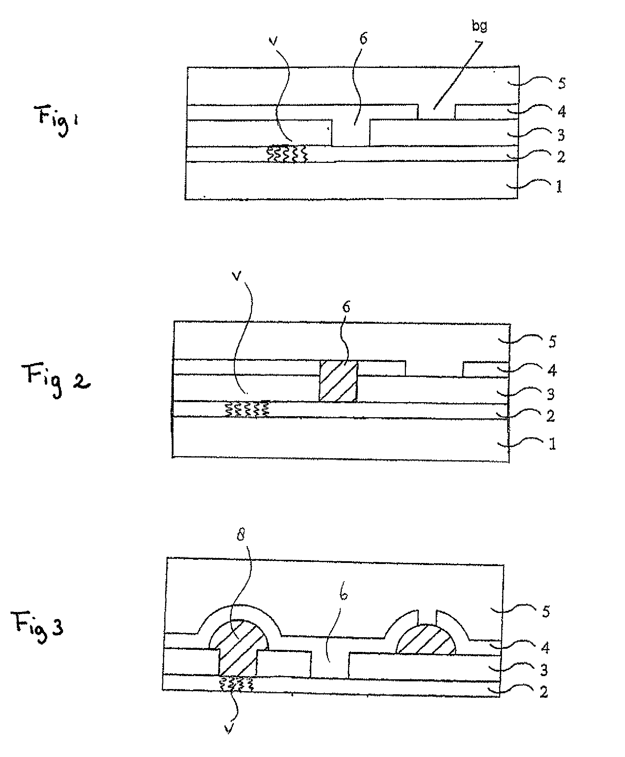

This embodiment is illustrated in Fig 1. It is important to note that the present invention is not limited to or by what is depicted in this figure.

A further embodiment of the present invention comprises the general steps of:
- providing a substrate (1) which is either a transparent permanent substrate or a temporary substrate
- applying a transparent conductive oxide layer onto the substrate and ensuring vitrification of a section (v) of the transparent conductive oxide layer.
- applying a photovoltaic layer (3) (PV layer) onto the TCO layer,
- applying a back electrode layer (4) onto the PV layer and applying a first groove through the back electrode and the PV layer onto the transparent conductive oxide layer, and a second groove (bg) in the back electrode layer down to the PV layer, and filling the first groove with a conductive material (6) to form an interconnect
- applying a covering layer (5) carrier on the back electrode, and
- where the substrate (1) is a temporary substrate, removing the temporary substrate.

This embodiment is illustrated in Fig 2. It is important to note that the present invention is not limited to or by what is depicted in this figure.

A further embodiment of the present invention comprises the following general steps:
- providing a substrate (1) which is either a transparent permanent substrate or a temporary substrate,
- applying a transparent conductive oxide layer onto the temporary substrate
- applying a photovoltaic (PV) layer (3) onto the transparent conductive oxide layer, providing a first groove through the PV layer onto the transparent conductive oxide layer, for example using a laser, applying such an amount of energy that the section (v) of the transparent conductive oxide layer below the groove is vitrified, providing a second groove through the PV layer, for example using a laser, applying such an amount of energy that the transparent conductive oxide layer below the groove is not vitrified, filling the first groove with an insulating material (8), and, if so desired, applying an insulating strip (9), and establishing a (precursor of) a conductive connection through the PV layer down to the transparent conductive oxide layer
- applying a back electrode (4) onto the PV layer, and providing a groove in the back electrode (4) down to the PV layer or, if present, down to the insulating strip (9)
- optionally applying a permanent carrier (5)
- where the substrate (1) is a temporary substrate, removing the temporary substrate.

This embodiment is illustrated in Fig 3. It is important to note that the present invention is not limited to or by what is depicted in this figure.

In this embodiment, but also in other embodiments of the present invention, a back electrode (4) is applied onto the PV layer, and a groove is provided in the back electrode (4) down to the PV layer or, if present, down to the insulating strip (9). The provision of this groove can be done by applying the back electrode and then providing a groove, e.g., using a laser. It is also possible to apply a lift-off compound on the PV layer, then provide a back electrode onto the PV layer and the lift-off compound, and then removing the lift-off compound. For further information on the use of a lift-off compound in the provision of grooves in solar cells, reference is made to the PCT application filed on December 21, 2007, claiming priority from EP 06126871.0, the relevant parts of which are herewith incorporated herein by reference.

As indicated above, the present invention also pertains to solar cell systems comprising a transparent conductive oxide layer, a photovoltaic layer, and a back electrode, the system being divided into at least two individual cells with the transparent conductive oxide layer of a cell being connected through a conductive interconnect with the back electrode of an adjacent cell, wherein the transparent conductive oxide layer is provided with an insulating interrupt on one side of the interconnect and the back electrode is provided with an interrupt on the other side of the interconnect, characterised in that the interrupt in the transparent front electrode is made up of vitrified transparent conductive oxide.
In one embodiment the vitrified interrupt in the TCO layer is accompanied by insulating material in the PV layer above the interrupt (e.g. as in figure 3). In another embodiment the vitrified interrupt in the TCO layer is not accompanied by insulating material in the PV layer above the interrupt (e.g., as in figures 1 and 2).
In one embodiment, the interconnect is filled with back electrode material (e.g., as in figure 1 and 3). In another embodiment the interconnect is filled with a separate conductive material (e.g. as in figure 2). In a further embodiment the interconnect is provided by fusing the back electrode with a silicon PV layer. The interconnect may be made by a groove through the PV layer only (e.g. as in figure 1 and 3), by a groove through the PV layer and the back electrode (e.g., as in figure 2), or by a groove through the PV layer, the back electrode and the transparent conductive oxide layer (not illustrated).
In one embodiment, the interrupt in the back electrode layer is accompanied by insulating material in the PV layer below the interrupt. In another embodiment the interrupt in the back electrode is not accompanied by insulating material in the PV layer below the interrupt (e.g., as in figures 1, 2, and 3).
As will be evident to the skilled person, the above embodiments on the interrupt and the interconnect can be combined as appropriate.

A further, and preferred, embodiment of the present invention comprises the general steps of:
- providing a substrate (1) which is either a transparent permanent substrate or a temporary substrate
- applying a transparent conductive oxide layer onto the substrate
- applying a photovoltaic layer (3) (PV layer) onto the transparent conductive oxide layer,
- providing a groove through the PV layer onto the transparent conductive oxide layer, for example using a laser, applying such an amount of energy that the section (v) of the TCO below the groove is vitrified, ensuring that on at least one side of the groove a non-vitrified section of the transparent conductive oxide layer is not overlayed with insulating PV layer material,
- applying an insulating material (8) on one side of the groove
- applying a back electrode layer (4) onto the PV layer and the insulating material (8), and in the groove itself and providing a groove in the back electrode layer down to the PV layer
- if so desired applying a covering layer (not shown) on the back electrode, and
- where the substrate (1) is a temporary substrate, removing the temporary substrate.

The crux of this embodiment is ensuring that on at least one side of the groove in the PV layer a non-vitrified section of the transparent conductive oxide layer is not overlayed with insulating PV layer material. In one embodiment, the non-vitrified section of the TCO layer is not overlayed by PV material at all. In another embodiment the non-vitrified section of the TCO layer is overlayed with PV layer material which has become conductive, for example, in the case, for example, a silicon-based PV layer, by melting and recrystallising of the PV layer.

The interconnect between the transparent conductive oxide layer and the back electrode is made by said non-vitrified section of the TCO being in conductive connection directly with back electrode applied in the groove (in the case where the non-vitrified section of the TCO layer is not overlayed by PV material), or by said non-vitrified section of the TCO being in conductive connection with a conductive section of the PV layer, which in turn is covered with back electrode.

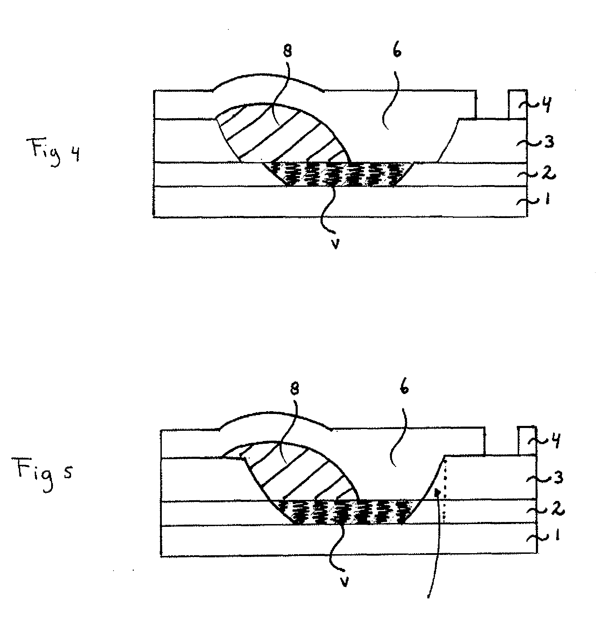

The version of this embodiment in which the interconnect between the transparent conductive oxide layer and the back electrode is made by the non-vitrified section of the TCO being in conductive connection directly with back electrode applied in the groove is illustrated in Fig 4.
The version of this embodiment in which the interconnect between the transparent conductive oxide layer and the back electrode is made by the non-vitrified section of the TCO being in conductive connection with a conductive section of the PV layer, which in turn is covered with back electrode is illustrated in Fig 5. The area indicated with the arrow is the part of the PV layer which has become conductive, e.g., through melting and recrystallisation.
Again, it is important to note that the present invention is not limited to or by what is depicted in these figures.

There are various ways in which a groove can be provided through the PV layer onto the transparent conductive oxide layer while, applying such an amount of energy that the section (v) of the TCO below the groove is vitrified, ensuring that on at least one side of the groove a non-vitrified section of the transparent conductive oxide layer is not overlayed with insulating PV layer material.
In one embodiment, said groove is applied in two steps, wherein in a first step a narrow groove is applied through the PV layer ensuring vitrification of the TCO layer below the groove, while in a second step a broader groove is applied over the first groove, in which at the edges of the narrow groove further PV material is removed or recystallised into a conductive form while the TCO below the broader groove is not vitrified further. An advantage of this embodiment is that it allows good process control.
In another embodiment, the groove is applied in a single step, where the amount of energy applied is selected such that a curved groove profile is obtained, in which the vitrified section of the transparent conductive oxide layer is narrower than the groove in the PV layer, e.g., as illustrated in Figs 4 and 5. Depending on, e.g., the nature of the PV layer, in this embodiment the molten PV layer may "withdraw" to the edges of the groove, as a result of which a non-vitrified section of the transparent conductive oxide layer becomes (substantially) free of PV layer, as illustrated in Fig 4. It is also possible for the PV layer above part of the non-vitrified section of the TCO to become conductive, e.g., through melting and recrystallisation, as illustrated in Fig 5.
One of the advantages of this system is that the interrupt of the TCO layer and the interconnect are present in the same groove. As compared to other systems this means that instead of two grooves though the PV layer only a single groove needs to be provided. This results in the process requiring less laser capacity.

The present invention also pertains to a solar cell system comprising a transparent conductive oxide layer, a photovoltaic layer, and a back electrode, the system being divided into at least individual cells with the transparent conductive oxide layer of a cell being connected through a conductive interconnect with the back electrode of an adjacent cell, wherein the transparent conductive oxide layer is provided with an insulating interrupt on one side of the interconnect and the back electrode is provided with an interrupt on the other side of the interconnect, characterised in that the interrupt in the transparent front electrode is made up of vitrified transparent conductive oxide, the interconnect between the transparent conductive oxide layer and the back electrode being made by a non-vitrified section of the TCO being in conductive connection directly with back electrode applied in the groove, or by a non-vitrified section of the TCO being in conductive connection with a conductive section of the PV layer, which in turn is covered with back electrode.

Examples of suitable transparent conductive oxides are mentioned above. F-doped SnO2 is preferred, because it can form a desired crystalline surface with a columnar light scattering texture when applied at a temperature above 400°C, preferably in the range of 500 to 600°C.
The TCO can be applied by means of methods known in the field, e.g., by means of Metal Organic Chemical Vapour Deposition (MOCVD), sputtering, Atmospheric Pressure Chemical Vapour Deposition (APCVD), PECVD, spray pyrolysis, evaporation (physical vapour deposition), electrodeposition, screen binding, sol-gel processes, etc. It is preferred to apply the TCO layer at a temperature above 250°C, preferably above 400°C, more preferably between 500 and 600°C, so that a TCO layer of the desired composition, properties and/or texture can be obtained. The thickness of the TCO layer is generally between 200 and 2000 nm, more in particular between 500 and 1000 nm.

The nature of the PV layer is not critical to the present invention. It should be noted here that in the present description the term "PV layer" or "photovoltaic layer" comprises the entire system of layers needed to absorb the light and convert it into electricity. Suitable layer configurations are known, as are the methods for applying them. Various thin film semiconductors can be used in manufacturing the PV layer. Examples are amorphous silicon (a-Si:H), microcrystalline silicon, polycrystalline silicon, amorphous silicon carbide (a-SiC), amorphous silicon-germanium (a-SiGe), and a-SiGe:H. In addition, the PV layer in the solar cell foil according to the invention may comprise CIS (copper indium diselenide, CuInSe2) PV cells, Cu(In,Ga)(Se,S)2 PV cells, CdTe (cadmium telluride) cells and/or dye sensitised and organic PV cells. As is known in the art, combinations of layers of various materials, so-called tandem cells, may also be applied. Suitable combinations include amorphous silicon with microcrystalline silicon, and amorphous silicon with amorphous silicon-germanium.
The PV layer preferably is an amorphous silicon layer when the TCO comprises a fluorine-doped tin oxide. In that case the PV layer will generally comprise a set, or a plurality of sets, of p-doped, intrinsic, and n-doped amorphous silicon layers, with the p-doped layers being situated on the side receiving the incident light.
The overall thickness of the PV layer, more particularly of all the a-Si layers together, will generally be of the order of 100 to 2000 nm.

The nature of the back electrode is also not critical to the present invention. Preferably it serves both as reflector and as electrode. Generally, the back electrode will have a thickness of about 50 to 500 nm, and it may comprise any suitable material having light reflecting properties, preferably a metal, for example, aluminium, silver, or a combination of layers of both. These metal layers preferably can be applied at a comparatively low temperature, e.g., below 150°C, by means of for instance (in vacuo) physical vapour deposition or sputtering. In the case of silver, it is preferred to first apply an adhesion promoter layer. TiO2 and ZnO are examples of suitable materials for an adhesion promoter layer and have the advantage of also possessing reflecting properties when applied in a suitable thickness, e.g., of the order of 20-200 nm, in particular 50-100 nm.

The nature of the insulating material used to fill grooves is not critical to the process according to the invention. It is within the scope of the skilled person to select a suitable material. As will be clear to the skilled person, the material to be selected must be able to withstand the conditions under which the solar cell foil is to be employed, e.g., in terms of UV, moisture, and temperature resistance. Examples of suitable materials are insulating synthetic resins such as polyurethanes, epoxy resins, epoxy amines, polyesters, and acrylates. Preferred methods of applying the insulating material are screen printing, ink jet, and dispensing techniques. Other suitable methods of applying the insulating material will be obvious to the skilled person. The insulating strips also can be made of said insulating materials and be applied, e.g., by means of ink jet, dispensing, or other printing techniques.

As was stated earlier the interconnect can be established in various ways. If it is established by way of first providing a groove and then filling it with a conductive material, suitable conductive materials include coatings of crosslinked polymers, such as the aforementioned ones, to which a conductive filler, such as particles of silver or flocks of nickel, is added. Such coatings are known to the skilled person. The coatings can be applied using well-known methods such as screen printing, printing, dispensing, or spraying techniques. It is also possible to provide a soldered connection. Alternatively, the conductive connection can be established via flame spraying of metals, e.g., aluminium. The technology of flame spraying is known to the skilled person.

The present invention can, int. al., be used in providing a series connection in a solar cell foil manufactured using a temporary substrate. Processes for manufacturing solar cell foils using a temporary substrate are known in the art. They are, e.g., described in WO 98/13882, WO 99/49483, WO 01/47020, WO 01/78165, WO 03/001602, and WO 05/015638, the disclosures of which are incorporated by reference.

Where a temporary substrate is used, it has to meet a number of requirements. It has to be sufficiently heat-resistant to withstand the conditions prevailing during the manufacture of the solar cell foil, more particularly, during the deposition of the TCO and the PV layer. It has to be strong enough to support the solar cell foil during its manufacture. It must be easily removable from the TCO layer without the latter being damaged in the process. Within the framework of these guidelines the skilled person will be able to select a suitable temporary substrate. Reference is made to the above-mentioned publications. It preferably is a foil of a metal or metal alloy. The main reasons for this are that in general such foils are resistant to high process temperatures, are slow to evaporate, and can be removed comparatively easily using known etching techniques. Suitable metals include steel, aluminium, copper, iron, nickel, silver, zinc, molybdenum, and alloys or multi-layers thereof . For economic reasons among others it is preferred to employ Fe, Al, Cu, or alloys thereof. Given their performance (and taking into account the matter of cost) aluminium, iron, and copper are most preferred. Suitable etchants and techniques for removing metals are known in the art.
It may be desirable, for instance when copper is used as the temporary substrate, to provide the temporary substrate with a non-reducing diffusion barrier layer, e.g., an anticorrosion layer, more particularly, zinc oxide.
If so desired, the temporary substrate may be provided with a transparent insulation spacer. Because of its transparency, this layer can be left on the TCO to serve as a protective layer for the TCO. The transparent insulation spacer preferably is made of glass.

For ease of removal, the temporary substrate preferably is as thin as possible. Of course, it has to be such that other layers can be deposited on it and it has to be able to hold these together, but this generally does not require it to be more than 500 microns (0.5 mm) thick. The thickness preferably is in the range of 1 to 200 microns (0.2 mm). Depending on the modulus of elasticity, the minimum thickness for a large number of materials will be 5 microns. Accordingly, a thickness of 5-150 microns, more particularly of 10-100 microns, is preferred.

As will be evident to the skilled person, where appropriate the solar cell foil may be provided with a carrier over the back electrode, or with an encapsulant, both as known to the skilled person. The provision of carrier over the back electrode is preferred where use is made of a temporary substrate process as described in the above references. For further information on the carrier in these embodiments reference is made to the above references, the relevant parts of which are herewith incorporated by reference. Suitable carrier layer materials include thin films of polymer, but also, for example, metal foils onto which an insulating (dielectric) surface layer has been applied The thickness of the carrier preferably is 75 microns to 10 mm. Preferred ranges are 100 microns to 6 mm and more in particular 150 microns to 300 microns.

## Claims

1. A process for providing a series connection in a solar cell system comprising the provision of a solar cell system comprising a transparent conductive oxide layer, a photovoltaic layer, and a back electrode, wherein the system is divided into at least two individual cells wherein the transparent conductive oxide layer of one cell is connected through a conductive interconnect with the back electrode of an adjacent cell, and the transparent conductive oxide layer is provided with an insulating interrupt on one side of the interconnect and the back electrode is provided with an interrupt on the other side of the interconnect, the process being **characterised in that** the interrupt in the transparent conductive oxide layer is provided through vitrification of the transparent conductive oxide layer.

2. A process according to claim 1 wherein the layer underlying the transparent conductive oxide layer is a substrate.

3. A process according to claim 1 or 2, wherein the vitrification process is carried out by providing the TCO layer with energy wherein the amount of energy provided is sufficient to vitrify the TCO layer, but insufficient to cut through the layer.

4. A process according to any one of the preceding claims wherein the vitrification of the TCO layer is effected using a laser.

5. A process according to any one of the preceding claims wherein the vitrification step is combined with the provision of a groove through a photovoltaic layer, in which the amount of energy provided is selected to be such that a groove is provided through the PV layer and at the same time sufficient to vitrify the TCO layer below the PV layer.

6. A process according to any one of the preceding claims comprising the following steps:
• providing a substrate (1) which is either a transparent permanent substrate or a temporary substrate,
• applying a transparent conductive oxide layer onto the temporary substrate
• applying a photovoltaic (PV) layer (3) onto the transparent conductive oxide layer, providing a first groove through the PV layer onto the transparent conductive oxide layer applying such an amount of energy that the section (v) of the transparent conductive oxide layer below the groove is vitrified, providing a second groove through the PV layer applying such an amount of energy that the transparent conductive oxide layer below the groove is not vitrified, filling the first groove with an insulating material (8), and establishing a (precursor of) a conductive connection through the PV layer down to the transparent conductive oxide layer
• applying a back electrode (4) onto the PV layer
• providing a groove in the back electrode (4)
• optionally applying a permanent carrier (5)
• where the substrate (1) is a temporary substrate, removing the temporary substrate.

7. A process according to any one of claims 1-5 which comprises the steps of:
• providing a substrate (1) which is either a transparent permanent substrate or a temporary substrate
• applying a transparent conductive oxide layer (2) onto the substrate
• applying a photovoltaic layer (3) (PV layer) onto the transparent conductive oxide layer,
• providing a groove through the PV layer onto the transparent conductive oxide layer applying such an amount of energy that the section (v) of the TCO below the groove is vitrified, ensuring that on at least one side of the groove a non-vitrified section of the transparent conductive oxide layer is not overlayed with insulating PV layer material,
• applying an insulating material (8) on one side of the groove
• applying a back electrode layer (4) onto the PV layer and the insulating material (8) and in the groove itself, and providing a groove in the back electrode layer down to the PV layer
• if so desired applying a covering layer (not shown) on the back electrode, and
• where the substrate (1) is a temporary substrate, removing the temporary substrate.

8. A solar cell system comprising a transparent conductive oxide layer, a photovoltaic layer, and a back electrode, the system being divided into at least two individual cells with the transparent conductive oxide layer of a cell being connected through a conductive interconnect with the back electrode of an adjacent cell, wherein the transparent conductive oxide layer is provided with an insulating interrupt on one side of the interconnect and the back electrode is provided with an interrupt on the other side of the interconnect, **characterised in that** the interrupt in the transparent front electrode is made up of vitrified transparent conductive oxide.

9. A solar cell system according to claim 7, wherein the interconnect between the transparent conductive oxide layer and the back electrode is provided by a non-vitrified section of the TCO being in conductive connection directly with back electrode applied in the groove, or by a non-vitrified section of the TCO being in conductive connection with a conductive section of the PV layer, which in turn is covered with back electrode.
